# EUROPÄISCHE PATENTSCHRIFT

(11) **EP 0 325 903 B1**
(45) Veröffentlichungstag und Bekanntmachung des Hinweises auf die Patenterteilung: **18.11.1993**
(21) Anmeldenummer: 88890298.8
(22) Anmeldetag: 30.11.1988
(51) Int. Cl.: H03F 3/70, G01M 15/00

(54) **Ladungsverstärkerschaltung**
Charge amplifier circuit
Circuit amplificateur de charge

(30) Priorität: 25.01.1988 AT 132/88
(43) Veröffentlichungstag der Anmeldung: 02.08.1989
(73) Patentinhaber: AVL Gesellschaft für Verbrennungskraftmaschinen und Messtechnik mbH.Prof.Dr.Dr.h.c. Hans List, 8020 Graz (AT)
(72) Erfinder: Wöss, Gerhard, Dipl. Ing., A-8043 Graz (AT); Leitmeier, Klaus, Dipl.Ing., A-8010 Graz (AT)
(74) Vertreter: Pinter, Rudolf, Dipl.-Ing.

(56) Entgegenhaltungen:
- EP-A- 0 253 016
- DE-A- 3 330 043
- DE-A- 3 632 221
- GB-A- 2 008 775
- GB-A- 2 085 599

## Beschreibung

Die Erfindung betrifft eine Ladungsverstärkerschaltung, deren Ausgang über eine Drift-Kompensationseinrichtung mit dem Signaleingang rückverbunden ist, wobei die Drift-Kompensationseinrichtung eine Auslöseeinrichtung enthält, über welche ein Auslösesignal zuführbar ist, nach dessen Auftreten über den Ausgang der Drift-Kompensationseinrichtung ein Kompensationsstrom entsprechend der jeweiligen Drift an den Signaleingang des Ladungsverstärkers gelegt wird.

Bei den heutzutage beispielsweise im Zusammenhang mit piezoelektrischen Meßsystemen verwendeten Ladungsverstärkern ist es notwendig, entweder möglichst hoch isolierende Eingangsstufen zu verwenden, die nur möglichst vernachlässigbare Eingangsleckströme verursachen, damit diese keine störende Drift der Ausgangsspannung zur Folge haben, oder aber eine allenfalls störende Drift der Ausgangsspannung durch entsprechende Kompensation auszugleichen und damit ihren Einfluß auf das tatsächliche meßsignal zu beseitigen.

Eine auf der Basis des zweitgenannten Prinzips arbeitende Schaltung der eingangs genannten Art ist beispielsweise aus der AT-PS 377.132 bekannt, wobei dort zur Drift-Kompensation am Ausgang des Ladungsverstärkers eine Schaltungsanordnung mit einem Gleichspannungsverstärker, einem A/D-Wandler, einem diesem nachgeschalteten D/A-Wandler und einem Widerstand vorgesehen ist, über welche vor der Messung in einer Abgleichphase automatisch die Eingangsleckströme durch einen Kompensationsstrom kompensiert werden, wobei dieser Strom während der anschließenden Meßphase konstant gehalten wird. Nach der Betätigung der Auslöseeinrichtung wird bei dieser bekannten Schaltung der zuletzt begonnene Digitalisierungsvorgang beendet und dann mit dem der zuletzt festgestellten Drift entsprechenden Kompensationsstrom der Eingang des Ladungsverstärkers beaufschlagt, solange sich das System im Zustand "Messen" befindet.

Die bekannte Schaltung eignet sich zwar sehr gut für die Durchführung einzelner Messungen, wie sie beispielsweise in der Ballistik im Zusammenhang mit der Bestimmung des Druckes in Rohrwaffen beim Schuß anfallen, ist jedoch für die Auswertung periodisch auftretender Meßsignale, und insbesonders wenn diese Perioden sehr kurz werden, wie beispielsweise bei der Auswertung von Druckmessungen an schnellaufenden Verbrennungskraftmaschinen, nur bedingt geeignet, da einerseits die A/D-Wandler bze. D/A-Wandler in dafür brauchbarer Ausführung relativ kompliziert und teuer sind und da andererseits bei der bekannten Schaltung auch keine Maßnahmen zur einfachen und zuverlässigen Einleitung einer periodischen Kompensation zwischen den einzelnen auftretenden Meßsignalen ausgeführt oder angeregt sind.

Im letztgenannten Zusammenhang ist beispielsweise aus der DE-OS 36 32 221 eine Anordnung bekannt geworden, die sich von der eingangs genannten im wesentlichen dadurch unterscheidet, daß nun zur Nullpunktstabilisierung des Ausgangs des Ladungsverstärkers das Ausgangssignal zu einem bestimmten Zeitpunkt, an dem die Sollspannung bzw. der Soll-Meßwert bekannt ist gemessen und sodann schlagartig durch eine Art "Reset" auf diesen Wert korrigiert wird. Einerseits steigt zufolge der für diese Einrichtung benötigten Zurverfügungstellung nicht nur einzelner, die periodischen Meßsignale irgendwie charakterisierender Auslösesignale sondern auch von stetig fortlaufenden Clock-Signalen bzw. Winkelmarkensignalen oder dergleichen der Hardware-Aufwand und andererseits kann durch das periodische Rücksetzen des Ladungsverstärkerausganges kein wirklich signifikantes Meßsignal für alle Driftvarianten sichergestellt werden.

Weitere Ladungsverstärkerschaltungen mit Drift-Kompensationseinrichtungen sind aus der GB-A-2 085 599 und der EP-A-0 253 016 bekannt.

Aufgabe der vorliegenden Erfindung ist es, eine Ladungsverstärkerschaltung der eingangs genannten Art so zu verbessern, daß die genannten Nachteile der bekannten derartigen Schaltungen vermieden werden und daß insbesonders auch bei periodisch auftretenden Meßsignalen, und speziell auch bei solchen mit kurzer Periode, eine wirkungsvolle Drift-Kompensation mit einfachen Mitteln möglich wird.

Dies wird gemäß der vorliegenden Erfindung dadurch erreicht, daß zum Driftausgleich zwischen am Signaleingang periodisch auftretenden Meßsignalen die Drift-Kompensationseinrichtung eine Sample/Hold-Einheit aufweist, die mit der entsprechend der Periode der Meßsignale getriggerten Auslöseeinrichtung zur Zuführung der Sample-Impulse in Verbindung steht. Die Sample/Hold-Einheit ist insbesonders im Zusammenhang mit relativ kurzen Perioden des Meßsignals, wie sie beispielsweise bei der Drucküberwachung der Zylinder einer Brennkraftmaschine auftreten, eine im wesentlichen gleichwertige aber viel einfachere und kostengünstigere Alternative zur Kombination der beiden A/D-und D/A-Wandler aus der genannten bekannten Schaltungsanordnung, die insbesonders im Zusammenhang mit der genannten Triggerung der Auslöseeinrichtung zur Zuführung der Sample-Impulse eine einfache, effektive und schnelle Kompensation sicherstellt. Es wird dabei die Neigung der die Nullpunktsdrift charakterisierenden Grundlinie des Meßsignals periodisch je nach der festgestellten Drift geändert, sodaß insgesamt durch die langsame Integratorwirkung eine sanfte Kompensation entsteht und Fehler im eigentlichen Meßwert auf vernachlässigbare Größe reduziert werden.

Nach einer besonders bevorzugten Ausgestaltung der Erfindung ist vorgesehen, daß die Auslöseeinrichtung mit einer externen Triggerung versehen ist, welche zumindest einen angeschlossenen Signalgeber zur Bereitstellung von dem Auftreten der die periodischen Meßsignale bewirkenden Vorgänge zuordenbaren Triggersignalen umfaßt. Der Signalgeber für diese externe Triggerung kann beispielsweise von einer mit einer Signalscheibe auf der Kurbelwelle oder der Nockenwelle einer Brennkraftmaschine zusammenwirkenden Lichtschranke oder einer entsprechenden induktiven oder kapazitiven Aufnahmeeinrichtung gebildet sein - ob die von diesem Signalgeber gelieferten Triggersignale gleichzeitig oder zeitverschoben zu den eigentlichen periodischen Meßsignalen auftreten ist relativ belanglos, solange nur eine Übereinstimmung in der Periode bzw. in einem n-fachen der Periode besteht. Soferne erforderlich, kann dann durch entsprechende Auswahl bzw. durch Zwischenschaltung von Zeitgliedern oder dergleichen erreicht werden, daß der das Auslösesignal repräsentierende Sample-Impuls zur richtigen Zeit - nämlich wenn das Meßsignal zwischen den periodisch auftretenden Spitzen auf Null bzw. das Minimum ist - abgegeben wird.

Nach einer weiteren Ausgestaltung der Erfindung kann im letztgenannten Zusammenhang auch vorgesehen sein, daß der Signalgeber an einer Signal-Auswahlschaltung in der Auslöseeinrichtung angeschlossen ist, welche durch Auswahl jedes n-ten Signals die Triggersignalfolge für die Bildung der Sample-Impulse bereitstellt. Damit kann beispielsweise bei Messung periodischer Vorgänge an Vier-Takt-Brennkraftmaschinen und einem an deren Kurbelwelle angebrachten Signalgeber für die Triggersignale sehr einfach nur jedes zweite Triggersignal für die Triggerung der Auslöseeinrichtung und damit die Abgabe des Sample-Impulses ausgewählt werden, um der sich über 720° Kurbelwinkel erstreckenden Gesamtperiode des Viertakt-Verfahrens Rechnung zu tragen. Es kann in diesem Zusammenhang weiters natürlich vorgesehen werden, daß die Auswahl, ob das erste oder das zweite der Triggersignale jeder 720°-Periode zur Triggerung der Auslöseeinrichtung führen soll, freigestellt bleibt.

Nach einer anderen besonders vorteilhaften Ausgestaltung der Erfindung ist die Auslöseeinrichtung mit einer internen Triggerung versehen, welche mit dem Signal-Ausgang des Ladungsverstärkers über eine Komparatoreinheit verbunden ist und jeweils zwischen dem Auftreten der festgestellten Meßsignale die Abgabe der Sample-Impulse auslöst. Damit ist der Zeitpunkt der jeweiligen Anpassung der Kompensation an die vorher festgestellte Drift völlig unabhängig von äußeren Einrichtungen allein aus dem Meßsignal bzw. aus dem Ausgangssignal des Ladungsverstärkers abgeleitet, was einen sehr geringen Hardware-Aufwand erfordert und die Durchführung von Messungen vielfältigster Art sehr erleichtert.

Nach einer weiteren Ausgestaltung der Erfindung kann die interne Triggerung im letztgenannten Zusammenhang einen Clock-Generator sowie eine dem Ausgang des eigentlichen Komparators nachgeschaltete Zähleinheit aufweisen, deren Ausgang bei Erreichen eines bestimmten Zählerstandes die Abgabe des Sample-Impulses auslöst. Dies ist eine sehr einfach realisierbare Möglichkeit zur Auslösung der Sample-Impulse zwischen den festgestellten Peaks des Meßsignals. Die Zähleinheit kann dabei beispielsweise getrennte Teile zur Verarbeitung der aufsteigenden bzw. der absteigenden Flanken des Meßsignals aufweisen, wodurch in Zusammenarbeit mit dem Komparator und dem Clock-Generator die Bestimmung der zwischen den Peaks des Meßsignals unterhalb einer gewissen Schwellsignalhöhe verbleibenden Zeit möglich ist. Diese Zeitspanne kanne dann beispielsweise halbiert werden, wobei in der nächsten Periode nach dem Ablauf dieser halben Zeitspanne der Sample-Impuls an die Sample/Hole-Einheit abgegeben wird.

Gemäß einer besonders bevorzugten weiteren Ausgestaltung der Erfindung ist ein Umschalter zur wahlweisen Zuführung des mit der externen oder der internen Triggerung erzeugten Sample-Impulses zur Sample/Hold-Einheit vorgesehen, was die Anwendungsmöglichkeiten der erfindungsgemäßen Ladungsverstärkerschaltung deutlich ausweitet und die optimale Abstimmung auf die jeweils vorgegebene Meßsituation ohne irgendwelche Umbauten an der Schaltungsanordnung ermöglicht.

Dem Signal-Eingang der Sample/Hold-Einheit kann nach einer anderen Weiterbildung der Erfindung ein Gleichspannungsverstärker vorgeschaltet sein, wobei der Ausgang dieser Einheit über einen weitern Gleichspannungsverstärker und einen diesem nachgeschalteten Widerstand am Signaleingang des Ladungsverstärkers liegt. Auf diese Weise kann auch ohne spezielles Augenmerk auf die exakte Abstimmung der einzelnen Komponenten eine ausreichende Kompensationswirkung und insbesonders ein ausreichend hoher Kompensationsstrom am Signaleingang des Ladungsverstärkers sichergestellt werden.

Der Verstärkungsfaktor des der Sample/Hold-Einheit nachgeschalteten Gleichspannungsverstärkers kann ebenso wie der nachgeschaltete Widerstand zumindest stufenweise änderbar sein, was insbesonders auch im Zusammenhang mit bezüglich der Empfindlichkeit verstellbaren Ladungsverstärkern große Vorteile für die verschiedensten Meßaufgaben mit sich bringt.

Nach einer weiteren vorteilhaften Ausgestaltung der Erfindung ist vorgesehen, daß in die Zuführung des Sample-Impulses zur Sample/Hold-Einheit eine Perioden-Überprüfungseinheit eingeschaltet ist, welche bei Überschreitung einer vorbestimmten Periodendauer den Sample-Impuls-Eingang auf "high" setzt und damit auf ständige Drift-Kompensation umschaltet. Wenn beispielsweise bei der Messung an einer Brennkraftmaschine diese nur mit sehr kleiner Drehzahl läuft, würde der Regelkreis sich insoferne aufschaukeln, als die Periode dann so lange dauert, daß die Kompensationsregelung den Ladungsverstärker wieder in die nächste Sättigung laufen läßt. Wenn also die Periode der Peaks des Meßsignals groß ist bzw. - z.B. wegen stehender Brennkraftmaschine - überhaupt defakto unendlich wird, dann wird ständig und fortlaufend die Drift des Ausgangs kompensiert, womit naturgemäß auch keine sinnvolle Verarbeitung des Meßsignals mehr möglich ist. Eine Ausnahme wäre hier allenfalls die Verarbeitung sehr kurzzeitiger Signale, da diese von der eher langsamen Kompensation praktisch nicht betroffen würden. Der Vorteil dieser "Dauerkompensation" bei langen Perioden des Meßsignals ist der, daß bei dann wieder in kürzeren Abständen anfallenden Meßsignalen bzw. Peaks des Meßsignals der Ladungsverstärker bereits von anfang an bezüglich der Drift seines Ausgangs kompensiert ist, sodaß jegliches Einpendeln am Anfang einer neuerlichen Meßserie wegfällt.

Die Erfindung wird im folgenden anhand der in der Zeichnung teilweise schematisch dargestellten Ausführungsbeispiele und erklärenden Signaldiagramme näher erläutert.
Fig. 1 zeigt ein teilweise schematisches Schaltbild einer Ladungsverstärkerschaltung nach der vorliegenden Erfindung,
Fig. 2 zeigt ein Spannungs/Zeit-Diagramm eines in die Sättigung "driftenden" Ausgangssignals eines unkompensierten Ladungsverstärkers,
Fig. 3 zeigt eine beispielsweise den Kompressionsdruck an einer Vier-Takt-Brennkraftmaschine repräsentierende Signalfolge mit zugehörigen Triggersignalen einer externen Triggerung sowie zugehörigen Auslösesignalen für die Drift-Kompensationseinrichtung nach der vorliegenden Erfindung,
Fig. 4 zeigt in einem Spannungs/Zeit-Diagramm die Auswirkung der Drift-Kompensation nach der vorliegenden Erfindung auf das Ausgangssignal des Ladungsverstärkers und
Fig. 5 zeigt anhand eines weitern Spannungs/Zeit-Diagramms samt zugehörigem Auslöseimpuls-Diagramm eine erfindungsgemäße Möglichkeit zur internen Drift-Kompensation;
Fig. 6 schließlich zeigt ein schematisches Schaltbild einer weiteren erfindungsgemäßen Ladungsverstärkerschaltung in detaillierterer Ausführung.

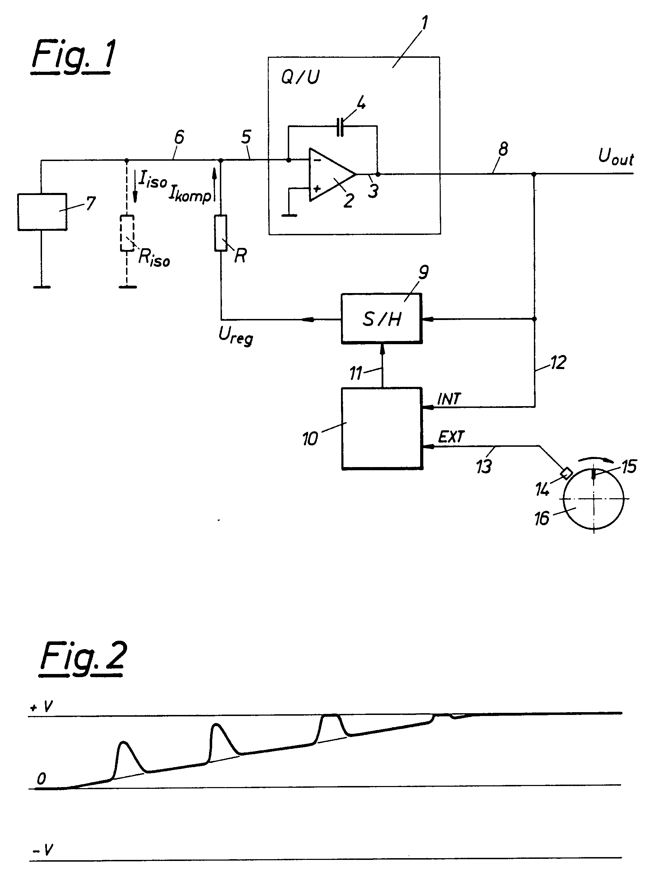

Der Ladungsverstärker 1 der Ladungsverstärkerschaltung nach Fig. 1 umfaßt im wesentlichen einen Operationsverstärker 2, dessen Ausgang 3 über einen Kondensator 4 auf den Signaleingang (-) rückgekoppelt ist. Abweichend von dieser Ausführung könnte der Ladungsverstärker 1 aber auch auf beliebig andere, dem Fachmann bekannte geeignete Weise realisiert sein. Am Signaleingang 5 des Ladungsverstärkers 1 (und damit hier am Signaleingang (-) des Operationsverstärkers 2) is über eine Leitung 6 ein piezoelektrischer Meßwertaufnehmer 7 angeschlossen, der auf hier nicht weiter dargestellte Art beispielsweise zur Kompressionsmessung an einer Brenkraftmaschine dienen kann.

Zufolge nicht vermeidbarer Isolationswiderstände (symbolisiert durch den strichliert eingezeichneten Widerstand Rᵢₛₒ) fließt ein Leckstrom Iᵢₛₒ, der - Nicht-Kompensation vorausgesetzt - zufolge der integrierenden Wirkung des Ladungsverstärkers 1 das Ausgangssignal auf der Leitung 8 so wie in Fig. 2 angedeutet driften läßt. Hier ist anzumerken, daß die Verhältnisse gemäß Fig. 2 übertrieben dargestellt sind - bei heutzutage üblichen Ladungsverstärkern ist bezogen auf die z.B. in üblichen Drehzahlbereichen einer Brennkraftmaschine auftretenden periodischen Meßsignale die Drift wesentlich geringer als in Fig. 2 dargestellt, was hier aber zur Erklärung bedeutungslos ist. Auch die in Fig. 2 eingetragenen Sättigungs-Pegel sind nur als Beispiele anzusehen.

Um nun zwischen den periodisch auftretenden Meßsignalen einen Driftausgleich durchführen zu können, ist der Ausgang (Leitung 8) des Ladungsverstärkers 1 mit einer Sample/Hold-Einheit 9 verbunden, die ihrerseits über einen Widerstand R wieder auf den Signaleingang 5 rückkoppelt. Über eine Auslöseeinrichtung 10 werden auf einer Leitung 11 Sample-Impulse als Auslösesignal der Sample/Hold-Einheit 9 zugeführt, die im zeitlichen Bereich zwischen den einzelnen Meßsignalen liegen und die Abgabe einer der jeweils gemessenen Drift entsprechenden Kompensationsspannung U_{reg} bewirken. Über den Widerstand R liegt damit ein Kompensationsstrom I_{comp} am Signaleingang 5 an.

Die Triggersignale für die Auslöseeinrichtung 10 können entweder über eine Leitung 12 intern aus dem Meßsignal bzw. aus dessen Peak-Folge erzeugt oder aber extern über eine Leitung 13 von einem angeschlossenen Signalgeber 14, der beispielsweise eine Signalmarke 15 an einer mit der Kurbelwelle der Brennkraftmaschine drehenden Scheibe 16 abtastet, bezogen werden.

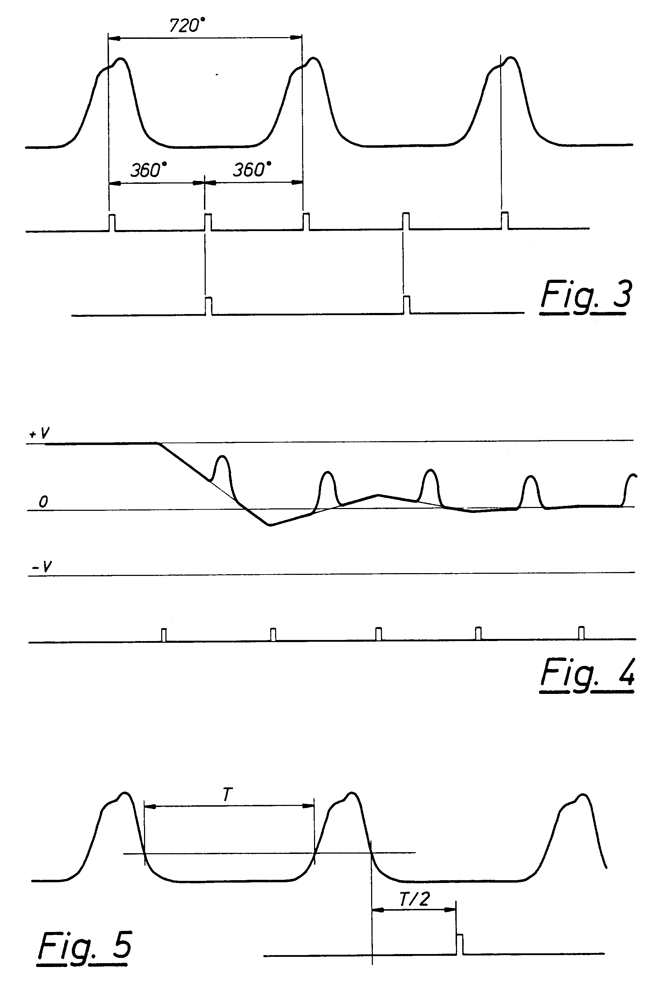

Gemäß Fig. 3 ist oben das eigentliche Meßsignal, also beispielsweise das alle 720° Kurbelwinkel auftretende Kompressionssignal einer Vier-Takt-Brennkraftmaschine aufgetragen. Die darunter liegende Signalfolge repräsentiert die beispielsweise gemäß Fig. 1 auf der Leitung 13 gelieferten Signale des Signalgebers 14 einer Kurbelwinkelmarke, die gemäß dem Arbeitsdiagramm der Vier-Takt-Brennkraftmaschine nicht nur am Kompressions-OT sondern auch am Auspuff-OT auftreten. Durch eine geeignete Schaltungsanordnung wird nun gemäß dem in Fig. 3 unten dargestellten Impulszug dafür gesorgt, daß nur die zwischen den einzelnen Peaks des Meßsignals liegenden Triggersignale zu Sample-Impulsen werden, sodaß die Drift tatsächlich ohne Beeinflussung des eigentlichen Meßsignals wie beschrieben korrigiert werden kann.

Abgesehen von der gemäß Fig. 3 gezeigten Lage der Triggersignale in Übereinstimmung mit den jeweiligen Totpunkten könnte natürlich auch eine um einen konstanten Kurbelwinkelbetrag verschobene Triggersignalfolge verarbeitet werden, da ja nur darauf geachtet zu werden braucht, daß das Auslösesignal für die Drift-Kompensation in das Wellental zwischen den Peaks des Meßsignals - wo das Signal abgesehen von geringen Schwankungen üblicherweise Null sein sollte - fällt.

Die obere Signalfolge gemäß Fig. 4 zeigt ein Meßsignal, welches gemäß der rechten Seite von Fig. 2 zufolge der Drift des Ladungsverstärkers in die Sättigung gelaufen ist (linker Bereich in Fig. 4). Mit dem Beginn der Drift-Kompensation gemäß der vorliegenden Erfindung wird nun vorerst der maximale Kompensationsstrom an den Signaleingang des Ladungsverstärkers gelegt, womit naturgemäß etwas überkompensiert wird und die Basislinie des oberen Signalverlaufs in Fig. 4 über die Nullinie nach unten läuft. Demgemäß wird beim nächsten auftretenden Sample-Signal eine (nun schon geringere) Kompensation in die andere Richtung erfolgen; nach einigen Perioden ist der in Fig. 4 rechts angedeutete Zustand erreicht, bei dem die Basislinie des Meßsignals nur mehr um vernachlässigbare Größen um die Nullinie pendelt. Da es sich dabei stets um ein Pendeln der Anfangs- und Endwerte der einzelnen Kompensations-Zyklen um die Nullinie handelt, ist darüber hinaus der zumindest ungefähr in der Mitte auftretende eigentliche Meßwert von diesen Schwankungen praktisch unbeeinflußt.

In Fig. 5 ist nun noch dargestellt, daß die "signalfreie" Period T, in welcher das eigentliche Meßsignal unterhalb einer bestimmten Pegelschwelle liegt, auch durch geeignete Schaltungsmaßnahmen halbiert werden kann, wonach in der nächsten Periode zum Zeitpunkt T/2 nach dem Abfallen des Meßsignals unter den Pegelwert das Auslösesignal abgegeben werden kann. Auf diese Weise können sehr einfach auch während der Messung schwankende Periodenlängen - beispielsweise zufolge von Drehzahlschwankungen einer Brennkraftmaschine - berücksichtigt werden.

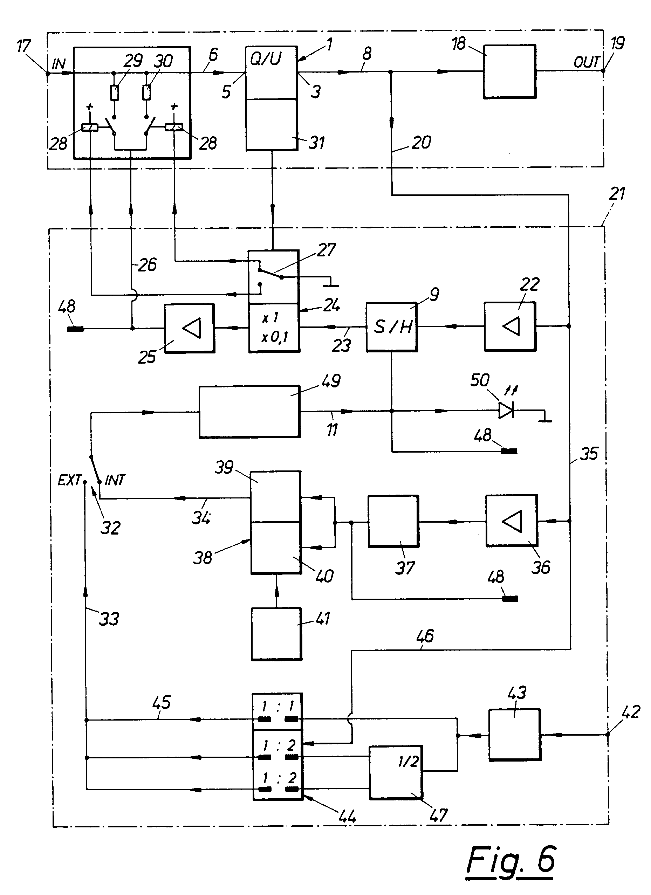

In Fig. 6 ist links oben ein Eingang 17 für den hier nicht weiter dargestellten Meßwertaufnehmer (7 gemäß Fig. 1) angedeutet, der über die Leitung 6 wiederum mit dem Signaleingang 5 des eigentlichen Ladungsverstärkers 1 verbunden ist. Der Ausgang 3 desselben führt einerseits zu einer Einheit 18, die zusätzliche, hier nicht weiter interessante Filter-, Verstärker- oder sonstige gewünschte Funktionen bzw. Einflüsse auf das am Ausgang 19 abgreifbare Meßsignal hat.

Über eine Leitung 20 ist die hier insgesamt mit 21 bezeichnete Drift-Kompensationseinrichtung angeschlossen, wobei hier nun vor der Zuführung des Ausgangssignals des Ladungsverstärkers 1 zur Sample/Hold-Einheit 9 ein Gleichspannungsverstärker 22 vorgeschaltet ist. Der Ausgang der Einheit 9 liegt über eine Leitung 23 und eine Umschalteinrichtung 24 an einem weiteren Gleichspannungsverstärker 25, der über eine Leitung 26 wahlweise über den Schalter 27 der Umschalteinrichtung 24 bzw. über angeschlossene Relais 28 auf zwei verschieden große Widerstände 29 bzw. 30 durchschaltbar ist. Diese Widerstände liegen (sowie der entsprechende Widerstand R in Fig. 1) wieder auf der Leitung 6 und damit am Signaleingang 5 des Ladungsverstärkers 1. Abgesehen von der genannten Umschaltmöglichkeit zwischen den Widerständen 29, 30 besteht über die mit der Empfindlichkeitseinstellung 31 des Ladungsverstärkers 1 gekoppelte Umschalteinrichtung 24 auch die Möglichkeit, die Verstärkung des Gleichspannungsverstärkers 25 stufenweise umzuschalten, sodaß sich in weiten Grenzen Anpassungen der Kompensationseinrichtung an verschiedenste, von den Meßaufgaben bzw. den verwendeten Meßwertaufnehmern vorgegebene Umstände erzielen läßt.

Über einen Umschalter 32 kann der Sample/Hold-Einheit 9 über die Leitung 11 wahlweise ein über die Leitung 33 zugeführter, extern dargestellter Sample-Impuls oder aber über die Leitung 34 ein entsprechender, intern dargestellter Sample-Impuls zugeführt werden. In der in Fig. 6 dargestellten "Intern"-Stellung wird das Meßsignal vor dem Gleichspannugsverstärker 22 über eine Leitung 35 abgezweigt und einem weiteren Gleichspannungsverstärker 36 sowie anschließend einem Komparator 37 zugeführt. Das Ausgangssignal des Komparators gelangt nun an eine Zähleinheit 38 mit Abwärtszähler 39 und Aufwärtszähler 40, welche weiters mit einem Clock-Generator 41 verbunden ist. Damit läßt sich unmittelbar die im Zusammenhang zu Fig. 5 beschriebene Betriebsweise der Kompensation realisieren, auf die hier zur Vermeidung von Wiederholungen nicht nochmals eingegangen werden soll. Das gemäß Fig. 5, unten, abgegebene Auslösesignal bzw. der entsprechende Sample-Impuls kommt dann über die Leitung 34 wie beschrieben zur Sample/Hold-Einheit.

In der anderen, "Extern"-Schaltstellung wird ein über einen Eingang 42 von einem hier nicht dargestellten Signalgeber (siehe z. B. 14 in Fig. 1) geliefertes externes Triggersignal, bzw. die in einem Komparator 43 aufbereitete Signalfolge, einer Auswahleinheit 44 zugeführt, die entweder (beispielsweise bei einem Zweitakt-Motor mit an der Kurbelwelle angebrachten Signalmarke) diese Signalfolge in der oberen Stufe unmittelbar über die Leitung 45 auf die Leitung 33 durchläßt, oder aber in den unteren beiden Stufen (beispielsweise im Zusammenhang mit der Kompressionsmessung an einer Vier-Takt-Brennkraftmaschine, bei der eine Markierung an einer Kurbelwellenscheibe oder dergleichen vorgesehen ist) eine interne Einflußnahme auf das tatsächlich zur Auslösung des Sample-Signals verwendete Triggersignal ermöglicht - diese interne Einflußnahme ist hier über eine Leitung 46 nur angedeutet. Die Einheit 47 dient dabei zur Halbierung der über den Eingang 42 gelieferten externen Triggersignalfolge.

Der Vollständigkeit halber ist im Zusammenhang mit Fig. 6 an dieser Stelle auch noch auf Meß- bzw. Testpunkte 48 zu verweisen, die jedoch mit der Schaltung selbst bzw. mit der Art der durchgeführten Drift-Kompensation nichts zu tun haben.

Weiters ist bei der Schaltungsanordnung nach Fig. 6 noch eine Perioden-Überprüfungseinheit 49 vorgesehen, welche in die Zuführung des Sample-Impulses vom Umschalter 32 zur Sample/Hold-Einheit 9 eingeschaltet ist und bei Überschreitung einer vorbestimmten Periodendauer, hier beispielsweise 1,2 Sekunden, den Sample-Impuls-Eingang auf "high" setzt und damit auf ständige Drift-Kompensation umschaltet. Dies dient wie eingangs erwähnt dazu, daß bei längeren Perioden zwischen den einzelnen Peaks des Meßsignals eine Überkompensation und damit eine Aufschaukelung der Regelung verhindert werden kann. Über eine hier von einer LED gebildete Anzeige 50 kann der jeweilige Betriebszustand (z.B. ständig leuchtende Anzeige für ständige Kompensation und flackernde Anzeige für periodische Kompensation) abgelesen werden.

Schließlich ist noch darauf hinzuweisen, daß anstelle des gemäß den obigen Ausführungen stets vorgegebenen Sollwerts "Null" für den Ausgang des Ladungsverstärkers zum Zeitpunkt der jeweils neuen Drift-Kompensation natürlich auch durch geeignete Maßnahmen ein beliebiger anderer Sollwert vorgebbar wäre, womit die beschriebene Anordnung zu einem bestimmten Zeitpunkt auch auf eine bestimmte Spannung kompensieren könnte. Soferne zusätzlich eine Variation dieses Kompensations-Zeitpunkts gewünscht wird, kann natürlich beispielsweise über einen entsprchend viele Kurbelwinkelmarken abtastenden Geber, die entsprechende Signalfolge zusätzlich verarbeitet werden.

## Patentansprüche

1. Ladungsverstärkerschaltung, deren Ausgang über eine Drift-Kompensationseinrichtung (21) mit dem Signaleingang rückverbunden ist, wobei die Drift-Kompensationseinrichtung (21) eine Auslöseeinrichtung (10) enthält, über welche ein Auslösesignal zuführbar ist, nach dessen Auftreten über den Ausgang der Drift-Kompensationseinrichtung ein Kompensationsstrom entsprechend der jeweiligen Drift an den Signaleingang des Ladungsverstärkers (1) gelegt wird, **dadurch gekennzeichnet**, daß zum Driftausgleich zwischen am Signaleingang periodisch auftretenden Meßsignalen die Drift-Kompensationseinrichtung (21) eine Sample/Hold-Einheit (9) aufweist, die mit der entsprechend der Period der Meßsignale getriggerten Auslöseeinrichtung (10) zur Zuführung der Sample-Impulse in Verbindung steht.

2. Schaltung nach Anspruch 1, dadurch gekennzeichnet, daß die Auslöseeinrichtung (10) mit einer externen Triggerung versehen ist, welche zumindest einen angeschlossenen Signalgeber (14) zur Bereitstellung von dem Auftreten der die periodischen Meßsignale bewirkenden Vorgänge zuordenbaren Triggersignalen umfaßt.

3. Schaltung nach Anspruch 2, dadurch gekennzeichnet, daß der Signalgeber (14) an einer Signal-Auswahlschaltung (44) in der Auslöseeinrichtung angeschlossen ist, welche durch Auswahl jedes n-ten Signals die Triggersignalfolge für die Bildung der Sample-Impulse bereitstellt.

4. Schaltung nach Anspruch 1, dadurch gekennzeichnet, daß die Auslöseeinrichtung (10) mit einer internen Triggerung versehen ist, welche mit dem Signal-Ausgang (3) des Ladungsverstärkers (1) über eine Komparatoreinheit (37) verbunden ist und jeweils zwischen dem Auftreten der festgestellten Meßsignale die Abgabe der Sample-Impulse auslöst.

5. Schaltung nach Anspruch 4, dadurch gekennzeichnet, daß die interne Triggerung einen Clock-Generator (41) sowie eine dem Ausgang des eigentlichen Komparators (37) nachgeschaltete Zähleinheit (38) aufweist, deren Ausgang bei Erreichen eines bestimmten Zählerstandes die Abgabe des Sample-Impulses auslöst.

6. Schaltung nach Anspruch 2 und 4, dadurch gekennzeichnet, daß ein Umschalter (32) zur wahlweisen Zuführung des mit der externen oder der internen Triggerung erzeugten Sample-Impulses zur Sample/Hold-Einheit (9) vorgesehen ist.

7. Schaltung nach einem der Ansprüche 1 bis 6, dadurch gekennzeichnet, daß dem Signal-Eingang der Sample/Hold-Einheit (9) ein Gleichspannungsverstärker (22) vorgeschaltet ist, und daß der Ausgang dieser Einheit (9) über einen weiteren Gleichspannungsverstärker (25) und einen diesem nachgeschalteten Widerstand (R;29,30) am Signaleingang (5) des Ladungsverstärkers (1) liegt.

8. Schaltung nach Anspruch 7, dadurch gekennzeichnet, daß der Verstärkungsfaktor des der Sample/Hold-Einheit (9) nachgeschalteten Gleichspannungsverstärkers (25) ebenso wie der nachgeschaltete Widerstand (29,30) zumindest stufenweise änderbar ist.

9. Schaltung nach einem der Ansprüche 1 bis 8, dadurch gekennzeichnet, daß in die Zuführung des Sample-Impulses zur Sample/Hold-Einheit (9) eine Perioden-Überprüfungseinheit (49) eingeschaltet ist, welche bei Überschreitung einer vorbestimmten Periodendauer den Sample-Impuls-Eingang auf "high" setzt und damit auf ständige Drift-Kompensation umschaltet.

## Claims

1. Charge amplifier circuit, of which the output is fed back through a drift compensation device (21) to the signal input, the drift compensation device (21) containing a triggering device (10) by which a triggering signal is supplied, after the occurrence of which a compensation current corresponding to the prevailing drift is applied to the signal input of the charge amplifier (1) through the output of the drift compensation device, **characterised in that**, for balancing the drift between measurement signals periodically occurring at the signal input, the drift compensation device (21) has a sample/hold unit (9) which is connected to the triggering device (10) triggered in accordance with the periods of the measurement signals, for supplying the sampling pulses.

2. Circuit according to Claim 1 characterised in that the triggering device (10) is provided with external triggering which includes at least one connected signal generator (14) for forming trigger signals associated from the occurrence of the processes causing the periodic measurement signals.

3. Circuit according to Claim 2 characterised in that the signal generator (14) is connected to a signal-selecting circuit (44) in the triggering device, this selection circuit providing by selection of every nth signal the sequence of trigger signals for forming the sampling pulses.

4. Circuit according to Claim 1 characterised in that the triggering device (10) is provided with internal triggering which is connected through a comparator unit (37) to the signal output (3) of the charge amplifier (1) and initiates the delivery of the sampling pulses respectively between the occurrences of the measuring signals which are observed.

5. Circuit according to Claim 4 characterised in that the internal triggering comprises a clock generator (41) as well as a counter unit (38) following the output of the actual comparator (37) the output of which initiates the delivery of the sampling pulse when a predetermined state is reached on the counter.

6. Circuit according to Claim 2 and 4 characterised in that a change-over switch (32) is provided for supplying at will to the sample/hold unit (9) the sampling pulses produced by the external or the internal triggering.

7. Circuit according to one of Claims 1 to 6 characterised in that the signal input of the sample/hold unit (9) has a DC amplifier (22) connected ahead of it and that the output of this unit (9) is connected to the signal input (5) of the charge amplifier (1) through a further DC amplifier (25) and a resistor (R;29,30) connected following it.

8. Circuit according to Claim 7 characterised in that the amplification factor of the DC amplifier (25) which follows the sample/hold unit (9) as well as the resistor (29,30) which follows it is variable, at least in steps.

9. Circuit according to one of Claims 1 to 8 characterised in that there is inserted in the feed of the sampling pulses to the sample/hold unit (9) a period-monitoring unit (49) which, when a predetermined time period is exceeded, sets the sampling pulse input to "high" and thereby changes over to continuous drift compensation.

## Revendications

1. Couplage d'amplificateur de charge dont la sortie est reliée à l'entrée du signal via un dispositif de compensation de dérive (21), le dispositif de compensation de dérive (21) comprenant un dispositif de déclenchement (10) par lequel peut être acheminé un signal de déclenchement après l'apparition duquel, via la sortie du dispositif de compensation de dérive, un courant de compensation est appliqué, conformément à la dérive respective à l'entrée du signal de l'amplificateur de charge (1),
**caractérisé par le fait**
que, pour la compensation de dérive entre les signaux de mesure apparaissant périodiquement à l'entrée du signal, le dispositif de compensation de dérive (21) présente une unité échantillonneur-bloqueur (9) en relation avec le dispositif de déclenchement (10) déclenché selon la période des signaux de mesure et destiné à acheminer les impulsions d'échantillonnage.

2. Couplage selon revendication 1,
**caractérisé par le fait**
que le dispositif de déclenchement (10) est pourvu d'un déclenchement externe comprenant au moins un transmetteur de signaux rattaché (14) destiné à mettre à disposition l'apparition des signaux de déclenchement attribuables aux opérations provoquant les signaux de mesure périodiques.

3. Couplage selon revendication 2,
**caractérisé par le fait**
que le transmetteur de signaux (14) est rattaché à un couplage de sélection de signaux (44) dans le dispositif de déclenchement, mettant à disposition, par sélection de chaque énième signal, la séquence de signaux de déclenchement pour la formation des impulsions d'échantillonnage.

4. Couplage selon revendication 1,
**caractérisé par le fait**
que le dispositif de déclenchement (10) est pourvu d'un déclenchement interne relié à la sortie du signal (3) de l'amplificateur de charge (1) via une unité comparateur (37) et déclenchant la libération des impulsions d'échantillonnage respectivement entre l'apparition des signaux de mesure constatés.

5. Couplage selon revendication 4,
**caractérisé par le fait**
que le déclenchement interne présente un générateur d'horloge (41) ainsi qu'un compteur (38) monté après la sortie du comparateur à proprement parler (37), compteur dont la sortie déclenche la libération de l'impulsion d'échantillonnage, lorsqu'un état déterminé du compteur est atteint.

6. Couplage selon revendications 2 et 4,
**caractérisé par le fait**
qu'un inverseur (32) est prévu pour acheminer, au choix, l'impulsion d'échantillonnage générée avec le déclenchement interne ou externe, vers l'unité échantillonneur-bloqueur (9).

7. Couplage selon une des revendications 1 à 6,
**caractérisé par le fait**
qu'un amplificateur de tension continue (22) est monté en amont de l'entrée du signal de l'unité échantillonneurbloqueur (9), et que la sortie de cette unité (9) se trouve à l'entrée du signal (5) de l'amplificateur de charge (1) via un autre amplificateur de tension continue (25) et une résistance montée derrière lui (R; 29, 30).

8. Couplage selon revendication 7,
**caractérisé par le fait**
que le facteur d'amplification de l'amplificateur de tension continue (25) monté après l'unité échantillonneur-bloqueur (9) de même que la résistance (29, 30) montée après lui sont modifiables, du moins progressivement.

9. Couplage selon une des revendications 1 à 8,
**caractérisé par le fait**
que, dans l'acheminement de l'impulsion d'échantillonnage vers l'unité échantillonneur-bloqueur (9), une unité de contrôle des périodes (49) est activée, plaçant, en cas de dépassement d'une durée de période prédéterminée, l'entrée de l'impulsion d'échantillonnage sur "high", et commutant donc sur une compensation permanente de dérive.
